(19) Europäisches Patentamt

European Patent Office

Office européen des brevets

(11) EP 0 751 396 B1

(12) **EUROPEAN PATENT SPECIFICATION**

(45) Date of publication and mention
of the grant of the patent:
**23.10.2002 Bulletin 2002/43**

(51) Int Cl.⁷: **G01R 31/00**

(21) Application number: **96110170.6**

(22) Date of filing: **24.06.1996**

(54) **Monitoring the insulation in electric vehicles**

Überwachung der Isolation in elektrischen Fahrzeugen

Contrôle de l'isolation dans des véhicules électriques

(84) Designated Contracting States:
**DE ES FR GB SE**

(30) Priority: **27.06.1995 IT TO950536**

(43) Date of publication of application:
**02.01.1997 Bulletin 1997/01**

(73) Proprietor: **FIAT AUTO S.p.A.**
**10135 Torino (IT)**

(72) Inventors:
• **Guerzoni, Roberto**
**10045 Piossasco (IT)**

• **Varrone, Piergiorgio**
**10025 Pino Torinese (IT)**

(74) Representative: **Cerbaro, Elena, Dr. et al**
**STUDIO TORTA S.r.l.,**
**Via Viotti, 9**
**10121 Torino (IT)**

(56) References cited:
**WO-A-91/19205      DD-A- 279 958**

• **DATABASE WPI Week 4690 Derwent**
**Publications Ltd., London, GB; AN 90-342418**
**XP002011073 & DD-A-279 958 (VEB INGENIEUR**
**ENERG) , 20 June 1990**

**Description**

The invention relates to a method and a device for monitoring and signalling the absence of electrical insulation between traction unit and bodywork in electric vehicles.

As is known, in electric road vehicles the traction unit is electrically separated from the bodywork for reasons of safety. In the event of leakage or short-circuit between any point of the unit and the bodywork, faults or anomalies in the operation of the vehicle do not take place immediately and therefore it is not possible immediately to detect such leakages or short-circuits. The situation changes, however, when a second point of the unit comes into contact with the bodywork, especially if the contact takes place at the level of the intermediate blocks of the battery pack, as they are not protected by fuses and a short-circuit of the battery pack blocks causes a high current flow which can actually cause the said blocks to explode.

It is therefore useful to be able to have available a signalling of the existence of a leakage or a short-circuit between the traction unit and the bodywork when the first fault takes place, so as to be able to intervene before the second and more serious fault occurs.

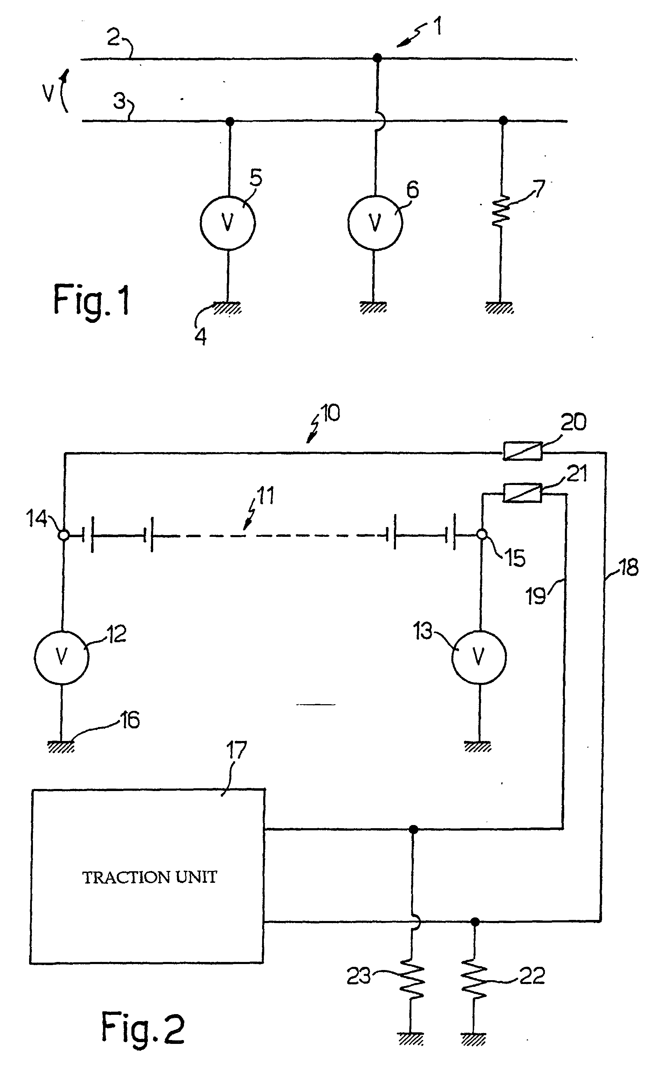

In loose electric lines one of the simplest and most frequently used methods for detecting leakage currents is based on the measurement of the voltages between each of the two phases and the earth, according to the wiring diagram, denoted as 1, shown in Fig. 1. A voltmeter 5 is connected between an electric line 2 and an earth 4, whilst a voltmeter 6 is connected between an electric line 3 and the earth 4. If there are no leakages between the electric lines 2, 3 and the earth 4, the voltmeters 5 and 6 show one and the same value, equal to half the line voltage V. Let us assume, however, that there is a leakage represented in Fig. 1 by a resistor 7 connected between the electric line 3 and the earth 4. The presence of the resistor 7 causes the voltmeter 5 connected to the electric line 3 to show a voltage value which is lower than that shown by the voltmeter 6 by a quantity proportional to the value of the leakage resistor 7 and to its own internal resistance.

In electric vehicles the above method is applied according to the diagram, denoted by 10, shown in Fig. 2. The first terminals of two voltmeters 12 and 13, particularly the voltmeter 12 to a negative pole 14 and the voltmeter 13 to a positive pole 15, are connected at the ends of a supply section 11 of the electric vehicle, constituted by the series connection of a number of batteries. The second terminals of the two voltmeters 12 and 13 are connected to an earth 16 (typically the bodywork of the vehicle). The negative pole 14 and the positive pole 15 of the supply section are connected to a traction unit 17 of the electric vehicle by means of two electric lines 18 and 19, along which two protective fuses 20 and 21 are interposed. In this case also, the absence of leakages with respect to the earth 16 causes the instruments 12 and 13 to measure the same value, equal to half the voltage across the supply section 11, whereas the presence of leakages on the electric lines 18 and 19, which can be represented by means of two resistors 22 and 23 connected between the electric lines 18 and 19 and the earth 16, causes the two voltmeters 12 and 13 to measure voltages which differ from one another in a manner proportional to the difference between the two leakage resistors 22 and 23.

A number of problems are associated with the use of this method of detecting leakages with respect to earth. If the leakage resistors 22 and 23 have the same resistance value, then the two voltmeters 12 and 13 show the same voltage value, equal to half the voltage of the supply section 11. In fact, generally speaking, a leakage resistor connected to a pole of the batteries tends to cancel out the effect of the other resistor connected to the other pole. In this case, therefore, it is not possible to detect the leakage from the difference between the two readings. Furthermore, as the supply section generally comprises several different boxes, it occupies rather high surface areas and volumes and if the leakage resistor is located precisely in the centre of the set of batteries of which the supply section 11 is composed; the voltmeters 12 and 13 will not indicate any leakage. Finally, in the case of leakages inside the supply section 11, this method of detection by means of voltmeters has a sensitivity which is greater when the leakage is close to the ends of the set of batteries and less when this leakage is close to the centre; it therefore becomes difficult to establish an acceptable threshold for all the positions and values of the leakage resistances.

DD 279958 A, on which the preamble of claim 1 is based, discloses a method for monitoring leakage in an electrically powered vehicle. An AC-generator with a known internal resistance is provided which applies an AC voltage to the power supply lines, and the AC voltage across the power supply lines is monitored in order to determining the leakage resistance. In particular, a voltage comparator connected to the power supply lines is provided which basically evaluates whether the leakage resistance is lower than a predetermined critical value and warns accordingly.

The object of the invention is therefore to provide a method and a device for monitoring and signalling the absence of electrical insulation between traction unit and bodywork in electric vehicles which do not have the disadvantages described above.

According to the invention a method for monitoring and signalling the absence of electrical insulation between a traction unit and a bodywork in electric vehicles is provided, as defined in claim 1.

The invention also relates to a device for monitoring and signalling the absence of electrical insulation between traction unit and bodywork in electric vehicles, as defined in claim 7.

For a better understanding of the invention a preferred embodiment will now be described, purely by way of non-exhaustive example, with reference to the accompanying drawings, in which:

- Fig. 1 shows a simplified diagram of the known method used in loose electric lines for detecting leakages;

- Fig. 2 shows a simplified diagram of the application of the known method to electric vehicles for detecting leakages;

- Fig. 3 shows a circuit diagram of the device to which the invention relates; and

- Fig. 4 shows a detailed diagram of an embodiment of the device to which the invention relates.

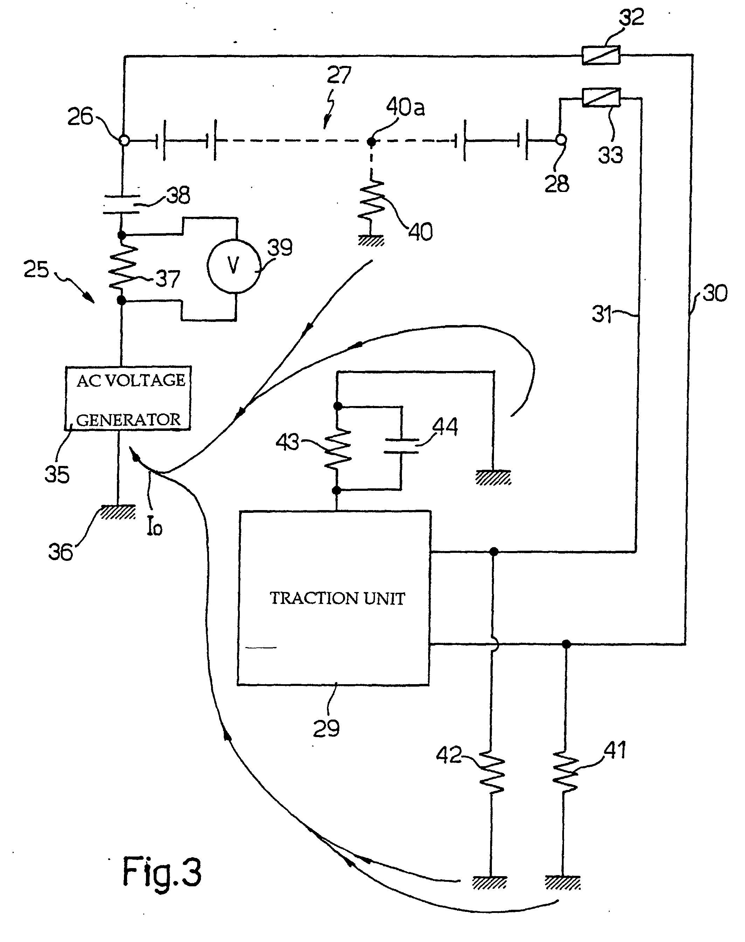

Fig. 3 shows the circuit diagram of the device to which the invention relates, denoted as 25. The device 25 is connected to one of the two poles 26, 28 (the negative pole 26 here) of a supply section 27 of the vehicle; in its turn the supply section 27 is connected to the traction unit 29 by means of the electric lines 30 and 31 on which two protective fuses 32 and 33 are interposed. In particular the device 25 comprises an AC voltage generator 35 having a first terminal connected to the bodywork 36 and a second terminal connected to a first terminal of a shunt resistor ("shunt") 37. A second terminal of the shunt resistor 37 is connected to a first terminal of a capacitor 38, which has a second terminal connected to the negative pole 26 of the supply section 27. A voltmeter 39 is arranged across the shunt resistor 37 to measure the AC voltage present at the shunt resistor 37.

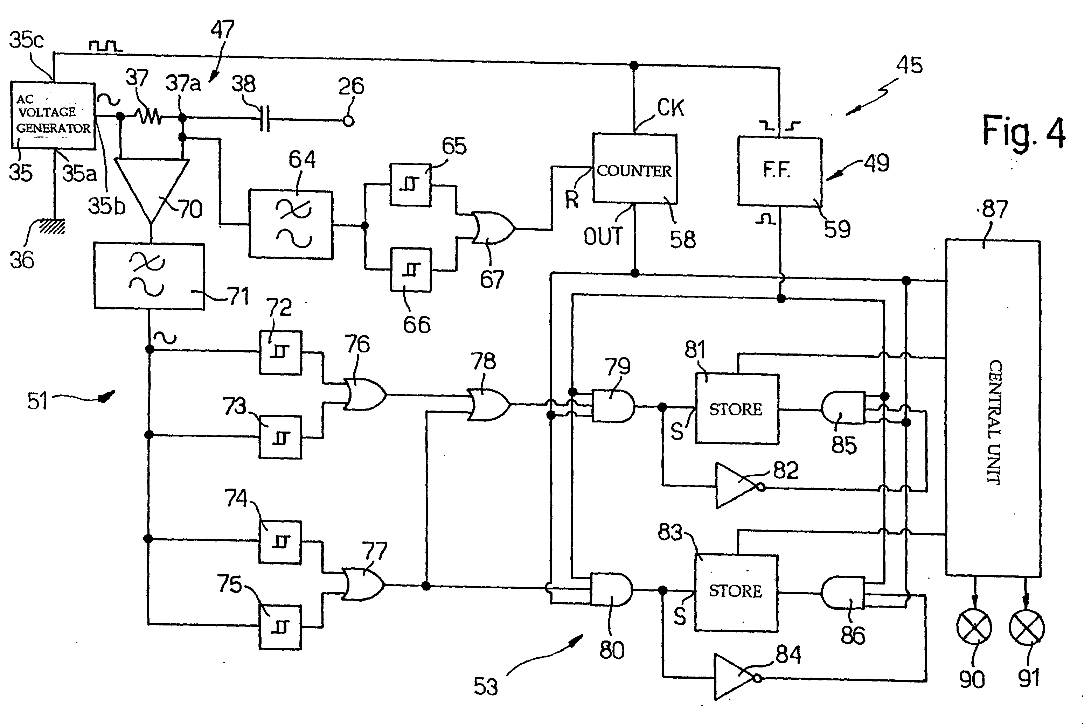

The device 25 is based on the principle of applying an AC voltage to the circuit whose insulation it is desired to test, with respect to the bodywork, so that a leakage current is generated if there is a leakage. In practice a current is introduced into the supply 27 and traction 29 section of the vehicle, an alternating current (represented symbolically in the illustration by the continuous lines ID) which closes again at the generator itself by means of the global leakage resistor, composed of the connection in parallel of all the leakage resistors which are present and are represented by the components 40-43. By measuring the voltage across the shunt resistor 37 it is possible to determine the leakage current on the basis of the resistance of the shunt resistor 37; by subtracting the measured voltage from the value of the voltage supplied by the generator 35, and on the basis of the leakage current measured, it is thus possible to obtain the global leakage resistance of the circuit. The leakage current and the global resistance can be calculated directly or indirectly on the basis of the voltage present at the shunt resistor 37, by means of the voltmeter 39, appropriately calibrated, or by means of a suitable logic (as described in greater detail, for example, with reference to Fig. 4).

In the device according to the-invention, the use of an AC voltage enables the same signal to be applied to all the leakage resistors 40-43 of the circuit and hence to obtain a reading which is independent of the position of the said leakage resistor(s).

In the circuit of Fig. 3, the de-coupling capacitor 38 serves to de-couple the DC voltage of the supply section 27 from the components 35, 37, 39 in such a way that this DC voltage has no influence on the measurement taken by the voltmeter 39. The presence of the de-coupling capacitor 38 can, however, create a number of disadvantages in the correct operation of the device 25. First of all, at the moment when a leakage appears in the circuit of the traction unit 29 or in the supply section 27, a DC voltage step is applied to the capacitor 38. This situation arises, for example, in the event of leakage on the node 40a between the batteries, as shown in Fig. 3 by the resistor 40. This step has a value equal to the algebraic sum of the voltage generated by the battery blocks incorporated into the grid which contains the leakage resistor (40 in this case) and the device 25. This means that a charging or discharging current of the capacitor 38, the duration of which depends on the value of the time constant of the RC circuit constituted by the capacitor 38 itself and the set of resistors 40 and 37, is flowing in the shunt resistor 37 in addition to the alternating current due to the generator 35.

Consequently, to enable the voltmeter 39 correctly to determine the value of the voltage across the shunt resistor 37, including in the case of a transient of the type described above, it is appropriate to be able to eliminate the effects of this transient. Furthermore, since the value of the AC voltage supplied by the generator 35 is only a few volts, whereas the DC voltage step applied to the capacitor 38 can actually reach hundreds of volts, the reading of the leakage current can actually be blocked for a time equal to several times the above-mentioned time constant, because of the limitation of the full scale of the voltmeter 39.

Finally, the entire traction unit has a stray capacitance with respect to the bodywork, represented by the capacitor 44 located in parallel to the leakage resistor 43 of the traction circuit. This stray capacitance is frequently of a value which is not negligible and its reactance is inversely proportional both to the frequency of the signal supplied by the generator 35 and to the value of the capacitance of the capacitor 44 itself. This capacitance can, therefore, imply errors of detection in the leakage current and hence, for a correct determination of the leakages due to lack of insulation, it is appropriate to eliminate the effects of this stray capacitance also.

To remedy the disadvantage of the voltage step, according to a feature of the invention the updating of the reading of the voltage at the shunt resistor 37 is blocked for a time exceeding the time the phenomenon requires to expend itself; furthermore, a filter with a long time constant is arranged upstream of the element which carries out the reading of the voltage at the shunt resistor 37 (the voltmeter 39 in Fig. 3) so that the above-mentioned voltage step does not cause appreciable variations of the value read off before the blocking of the updating.

To remedy the disadvantage due to the presence of the reactive component of the leakage current, the AC voltage generator 35 is selected to be of a sufficiently low frequency as to render negligible the reactance of the capacitor 44 with respect to the overall leakage resistance. By taking a hypothetical value of the capacitance of the capacitor 44 of approx. 100 nF (a reasonable value for present-day units), wishing to record a value of overall leakage resistance of approx. 1 MW and by obliging the reactance of the capacitor 44 to be at least about ten volts greater than the overall leakage resistance, a value of this reactance equal to 10 MW is obtained.

Therefore, with the value of this reactance equal to:

$$X_c = \frac{1}{2 \cdot \pi \cdot f \cdot C}$$

it is possible to determine the value of the frequency at which the generator 35 should operate, or:

$$f = \frac{1}{2 \cdot \pi \cdot X_c \cdot C} = \frac{1}{2 \cdot \pi \cdot 10 \cdot 10^6 \cdot 0.1 \cdot 10^{-6}} = 0.15 \text{ Hz}$$

The frequency of the generator is therefore advantageously fixed at 0.1 Hz.

The blocking and subsequent release of the updating of the measurement of the voltmeter 39 to eliminate the effects of the insertion step brings about a delay of a few tens of seconds in the detection of a change in the insulation. This slowness in indicating any poor insulation is, however, acceptable for the intended application since it in no way jeopardizes the use of the electric vehicle: this indication in fact serves solely as an invitation to seek technical assistance as soon as possible and in no way is the user's safety compromised by a delay of a few seconds.

In the device 25, the leakage current, being proportional to the instantaneous voltage of the generator 35, is cancelled out when the AC voltage supplied by the generator 35 passes through zero, for which reason the reading of this current loses any meaning at that point. Therefore, advantageously, the reading of the measurement of the voltmeter 39 or other voltage measuring instrument is enabled solely during the peaks of the positive and negative half-waves of the generator 35. This means that, at the frequency of 0.1 Hz, the updating of the value of the leakage current takes place only every 5 seconds. In this case also this slowness is not prejudicial to the functionality of this device.

It is also advantageous to distinguish between poor insulation and short-circuit, and to generate different indications in the two instances, as the short-circuit situation could be more dangerous to the integrity of the supply unit and to the safety of the user than one of poor insulation.

An embodiment of the monitoring and signalling device which takes account of the above considerations is shown in Fig. 4 and denoted by 45. The device 45 is connected to the negative pole 26 of the supply section (not shown) of the traction unit of the electric vehicle (also not shown), and comprises a section 47 capable of generating an AC voltage to be introduced into the traction circuit of the vehicle (not shown), of detecting an alternating leakage current which is proportional to the extent of the leakages present in that circuit and of generating a correlated voltage; a section 51 capable of evaluating the leakage resistance on the basis of the voltage generated in the section 47 and of generating signals indicative of resistance below pre-determined thresholds; a section 49 capable of outputting a window of reliability of the output signals of the section 51; and a section 53 capable of storing the signals coming from the section 51 in the reliability intervals indicated by the section 49 and of outputting the signals of slight leakage or short-circuit.

In detail, the section 47 comprises the AC voltage generator 35, advantageously achieved by means of an integrated circuit (device ICL 8038 from Harris), having a first terminal 35a connected to the bodywork 36, a second terminal 35b at which the sinusoidal voltage is present at the frequency of 0.1 Hz and a third terminal 35c at which a square wave is present at the same frequency of 0.1 Hz, shifted 90° out of phase with respect to the voltage at the terminal 35b. The second terminal 35b of the generator 35 is connected to a first terminal of the shunt resistor 37 whilst the terminal 35c is connected to the section 49. A second terminal 37a of the shunt resistor 37 is connected to the negative pole 26 of the supply section (not shown) via the de-coupling capacitor 38.

The section 49 comprises a low-pass filter 64 having a time constant of 10 ms, for example, and connected to the second terminal 37a of the shunt resistor 37. The output of the filter 64 is connected to the inputs of two voltage comparators 65 and 66 which output a high logic value when the input voltage is, respectively, greater than 10 V, for example, and lower than - 10 V. The outputs of the two voltage comparators 65 and 66 are connected to the inputs of an OR gate 67, the output of which is connected to a reset input R of a counter 58. A timer input CK of the counter 58 is connected to the terminal 35c of the generator 35 and the OUT output of the counter 58 is connected both to the section 53 to block the updating of the measurements and to a central unit 87 for signalling the window of reliability of the measurements. Finally the section 49 comprises a monostable (flip-flop) 59 for generating voltage pulses used to enable or disable the reading of the measurements taken by the section 51, as explained in greater detail above; in particular the device 59 outputs a rectangular pulse at every transition of the input signal (square wave).

The section 51 comprises a differential 70, the inputs of which are connected to the two terminals of the shunt resistor 37, which is used to measure the potential difference present across the resistor 37 itself and hence corresponding to the voltmeter 39 of Fig. 3. The output of the differential 70 is connected to a low-pass filter 71 having a time constant greater than that of the filter 64 and equal, for example, to 1 s. The output of the filter 71 is connected to two pairs of comparators 72, 73 and 74, 75, which output a high logic value when the voltage at their input corresponds to a global leakage resistance of less than 1 MW and, respectively, less than 10 KW. This recording is updated by means of two comparators so as to be able to carry out the comparison both for the positive half-wave and for the negative half-wave of the voltage at their input. The outputs of the comparators 72, 73 are connected to an OR gate 76 whilst the outputs of the comparators 74, 75 are connected to an OR gate 77. The outputs of the gates 76 and 77 are connected to another OR gate 78. The outputs of the gates 78 and 77 are connected to the section 53.

The section 53 comprises two AND gates 79 and 80, each with three inputs; the outputs of the counter 58, of the monostable 59 and of the OR gate 78 are connected to the inputs of the first AND gate 79; the outputs of the counter 58, of the monostable 59 and of the OR gate 77 are connected to the inputs of the AND gate 80. The outputs of the AND gates 79 and 80 are connected respectively both to the set inputs S of two memories 81 and 83 and to two inverters 82 and 84. The outputs of the inverters 82 and 84 are connected to an input of an AND gate 85 and, respectively, 86, each with three inputs, the inputs of which are also connected to the outputs of the counter 58 and of the monostable 59. Finally the outputs of the AND gates 85 and 86 are connected respectively to the R reset inputs of the memories 81 and 83, the outputs of which are connected to a central signalling unit 87, which in its turn controls two optical signalling elements, such as lamps 90, 91 located on the vehicle's dashboard.

The device 45 operates as follows. As has already been said with reference to Fig. 3, in the presence of a leakage with respect to the bodywork 36, an alternating current is originated in the ring constituted by the section 47, the supply and traction circuit 27, 29 of the vehicle as far as the point at which the leakage is present, the corresponding leakage resistor 40 or 41 or 42 or 43, and the bodywork 36.

The differential 70 measures the voltage of the shunt resistor 37 due to the leakage current and outputs a signal corresponding to the measured value. This signal is supplied to the low-pass filter 71 which filters it so as to eliminate high-frequency interference. The filtered signal is compared by the comparators 72-75 which generate a corresponding signal at the output when they detect a voltage higher in absolute value than a pre-determined threshold. In particular, the comparators 72, 73 have a threshold corresponding to a leakage resistance less than 1 MW (low leakage) whereas the comparators 74, 75 have a threshold corresponding to a leakage resistance less than 10 KW (short-circuit) and they communicate it to the section 53 via the OR gates 76-78.

The leakage signals present at the output of the OR gates 77 or 78 are inputted to the AND gates 79, 80, which send them to the corresponding memories 81, 82 only in the presence of the enabling instruction supplied by the counter 58 and by the monostable 59, as described below.

The signal present at the terminal 37a of the shunt resistor 37 is filtered by the filter 64 so as to eliminate high-frequency interference and then compared by the comparators 65 and 66. These comparators have a threshold, in absolute value, greater than 10 V, so as to detect any voltage steps at the node 37a and to generate a corresponding step signal. The output signals of the comparators 65, 66 are supplied to the OR gate 67, which in its turn generates a reset signal, supplied to the input R of the counter 58, so as to disable the counter 58. Consequently, the output of the counter 58 remains at the low logic level as long as the step signal persists. At the end of the step, the counter 58 begins to count the pulses supplied to its input CK and, at the end of the intended counting (4-5 time constants defined by the series connection of the resistors 37, 40-43 - Fig. 3 - and the capacitor 38), outputs a reliability window signal (high output of the counter 58).

The low-pass filter 64 conveniently has a lower time constant than that of the filter 71 so that the steps recognition portion (components 58, 64-67) of the section 49 intervenes more rapidly with respect to the section 51 and prevents the acquisition, by the section 53, of the measurement taken by the section 51 in the presence of an insertion step, as described in greater detail below.

The monostable 59 generates brief enabling pulses in correspondence with the peaks, positive and negative, of the voltage difference measured by the section 51, so as to enable the section 53 to acquire the measurement taken by the section 51 in correspondence with these voltage peaks, as explained in greater detail below. In practice these pulses (read-out phasing signal) are generated when both the rising edges and the falling edges of the square wave generated by the generator 35 at its terminal 35c are recognized.

The AND gates 79, 80 receive a high signal from the corresponding OR gate 78, 77 in the presence of a leakage resistance less than 1 MW and, respectively, 10 KW, and output this high signal solely in the presence of the reliability window signal from the counter 58 (or in the absence or with a certain delay from the end of an insertion step) and of the read-out phasing signal supplied by the monostable 59 (or in correspondence with the peaks of the AC voltage). The high signal outputted at the AND gates 79 or 79 is then stored by the corresponding memory 81, 83, the output of which is supplied to the central unit 87 so that it correspondingly supplies one of the lamps 90, 91 (or another optical and/ or acoustic signalling system).

In this phase, the output of the gates 85, 86 is always low since, in the presence of the read-out phasing pulses generated by the monostable 59, the gates 85, 86 receive the negated (low) signal outputted from the gates 79, 80 and, in the intervals between the read-out phasing pulses or in the presence of insertion steps, they are disabled by the section 49 at the same time as the gates 79, 80.

On the removal of the leakage present in the vehicle's traction or supply circuit the output of the gate or gates 78, 77 becomes low, the signal at the inputs S of the memories 81, 83 is low and the signal outputted by the inverters 82, 84 becomes high. The gates 85, 86 output reset signals for the memories 81, 83 as soon as enabled by the section 49.

The advantages of this device are as follows. Firstly, it permits any leakage greater than a given threshold to be signalled in a reliable manner as soon as it takes place. Furthermore, it is not sensitive to external interference and transient phenomena. Finally, it is simple and can be produced with inexpensive components, and thus has reduced manufacturing and installation costs.

Finally it will be clear that modifications and variations to the method and the device described and illustrated herein can be made without thereby departing from the scope of the invention, as defined in the attached claims. For example, the sections 49, 51, 53 can be produced in any manner, by means of a combinatorial circuit, as shown in Fig. 4 or by means of appropriate programmable logic means.

**Claims**

1. Method for monitoring and signalling the absence of electrical insulation between a traction unit (29) and a bodywork (36) in electric vehicles, said method comprising the steps of applying to said traction unit (29) an AC voltage related to the bodywork (36); detecting an alternating current flowing through said bodywork (36) due to the effect of said AC voltage; and determining the value of any leakage resistances on the basis of the value of said alternating current and said applied AC voltage; whereby said step of determining the value of any leakage resistances comprises the steps of comparing the leakage resistance with a first and a second pre-determined thresholds, signalling a poor insulation condition in the event the leakage resistance is lower than the first pre-determined threshold, and signalling a short-circuit condition in the event the leakage resistance is lower than the second pre-determined threshold.

2. Method according to Claim 1, **characterized in that** said step of applying an AC voltage comprises the step of connecting an AC voltage generator (35) to said traction unit (29).

3. Method according to Claim 2, **characterized in that** said step of detecting an alternating current comprises the step of connecting a shunt resistor (37) of known value in series with said voltage generator (35).

4. Method according to Claim 3, **characterized in that** said step of determining the value of leakage resistances comprises the step of connecting a calibrated voltmeter (39) across said shunt resistor (37).

5. Method according to one of Claims 2-4, **characterized in that** said step of detecting an alternating current comprises the step of eliminating DC components present in said traction unit (29).

6. Method according to Claim 5, **characterized in that** said step of eliminating DC components comprises the step of de-coupling said AC voltage generator (35) from said traction unit (29) with respect to DC.

7. Device (45) for monitoring and signalling the absence of electrical insulation between a traction unit (29) and a bodywork (36) in electric vehicles, said device (45) comprising: an AC voltage generator (35) to be connected between said traction unit (29) and said bodywork (36); means for detecting the current (37) flowing in said voltage generator (35); and means for determining leakage resistance (39; 49, 51, 53) on the basis of said current and said AC voltage generated by said generator (35); whereby said means for determining the leakage resistance (39; 49, 51, 53) comprise first comparator means (72, 73) comparing the leakage resistance with a first pre-determined threshold and outputting a poor insulation signal in the event the leakage resistance is lower than the first pre-determined threshold, and second comparator means (74, 75) comparing the leakage resistance with a second pre-determined threshold and outputting a short-circuit signal in the event the leakage resistance is lower than the second pre-determined threshold.

8. Device according to Claim 7, **characterized in that** said means for detecting the current (37) are decoupled from said traction unit (29) by means of capacitive means (38).

9. Device according to Claim 7 or 8, **characterized in**

**that** said means of detecting the current comprise a shunt resistor (37) arranged in series with said voltage generator (35).

10. Device according to Claim 9, **characterized in that** said means of determining the leakage resistance comprise a calibrated voltmeter (39) arranged in parallel with said shunt resistor (37).

11. Device according to Claim 9, **characterized in that** said means of determining the leakage resistance (49, 51, 53) comprise a measurement section (51) capable of generating said poor insulation signal and said short-circuit signal; a monitoring section (49) capable of outputting read-out enabling signals; and a storage section (53) capable of storing said leakage signal in the presence of said read-out enabling signals.

12. Device according to Claim 11, **characterized in that** said measurement section (51) comprises differential means (70) for determining the voltage across said shunt resistor (37) and said first comparator means (72, 73) connected to the output of said differential means (70).

13. Device according to Claim 12, **characterized in that** said measurement section (51) further comprises said second comparator means (74, 75), which are connected to the output of said differential means (70) and are capable of outputting said short-circuit signal in the event of an output signal from said differential means which is greater than a third pre-determined threshold.

14. Device according to one of Claims 11 to 13, **characterized in that** said monitoring section (49) comprises means which detect voltage steps (64-66) on said shunt resistor (37).

15. Device according to Claim 14, **characterized in that** said detecting means (64-66) comprise third comparator means (65, 66) capable of outputting a step signal when said voltage at said shunt resistor (37) exceeds a fourth pre-determined threshold and **in that** said monitoring section (49) also comprises inhibiting means (58) connected to said third comparator means and capable of generating a reliability window signal in the absence of said step signal and with a pre-determined delay from the end of said step signal.

16. Device according to Claim 15, **characterized in that** said measurement section (51) comprises differential means (70) for the detection of the voltage at said shunt resistor (37) and first filtering means (71) arranged downstream of said differential means and having a first time constant and **in that** said monitoring section (49) comprises second filtering means (64) arranged upstream of said third comparator means (65, 66) and having a second time constant less than said first time constant.

17. Device according to one of Claims 11-16, **characterized in that** said monitoring section (49) comprises peak detecting means (59) connected to said voltage generator (35) and capable of generating a read-out phasing signal in correspondence with the peaks of said AC voltage.

18. Device according to one of Claims 11 to 17, **characterized in that** it comprises visual and/or acoustic signalling means (90, 91) controlled by said storage means (53).


**Patentansprüche**

1. Verfahren zum Überwachen und Signalisieren des Fehlens der elektrischen Isolierung zwischen einer Antriebseinheit (29) und der Karosserie (36) von elektrischen Fahrzeugen, welches Verfahren die Schritte des Anlegens einer Wechselspannung an die Antriebseinheit (29) bezüglich der Karosserie (36), der Erfassung eines Wechselstromes, der aufgrund der Wirkung dieser Wechselspannung in der Karosserie (36) fließt, und der Bestimmung des Wertes von Leckwiderständen auf der Grundlage des Wertes des Wechselstromes und der anliegenden Wechselspannung umfasst, wobei der Schritt der Bestimmung des Wertes von Leckwiderständen die Schritte des Vergleichs des Leckwiderstandes mit einem ersten und einem zweiten vorbestimmten Schwellenwert, der Signalisierung schlechter Isolierung, wenn der Leckwiderstand unter einem ersten vorbestimmten Schwellenwert liegt, und der Signalisierung eines Kurzschlusses, wenn der Leckwiderstand unter einem zweiten vorbestimmten Schwellenwert liegt, umfasst.

2. Verfahren nach Anspruch 1, **dadurch gekennzeichnet, dass** der Schritt des Anlegens einer Wechselspannung den Schritt des Anschlusses eines Wechselspannungsgenerators (35) an die Antriebseinheit (29) umfasst.

3. Verfahren nach Anspruch 2, **dadurch gekennzeichnet, dass** der Schritt der Erfassung eines Wechselstromes den Schritt der Schaltung eines Nebenschlusswiderstandes (37) mit bekanntem Wert in Reihe zu dem Spannungsgenerator (35) umfasst.

4. Verfahren nach Anspruch 3, **dadurch gekennzeichnet, dass** der Schritt der Bestimmung des Wertes der Leckwiderstände den Schritt der Schaltung eines geeichten Voltmeters (39) über den Nebenschlusswiderstand (37) umfasst.

5. Verfahren nach einem der Ansprüche 2 - 4, **dadurch gekennzeichnet, dass** der Schritt der Erfassung des Wechselstromes den Schritt der Entfernung von Gleichspannungsanteilen in der Antriebseinheit (29) umfasst.

6. Verfahren nach Anspruch 5, **dadurch gekennzeichnet, dass** der Schritt der Beseitigung von Gleichspannungsanteilen den Schritt der Entkopplung des Wechselspannungsgenerators (35) von der Antriebseinheit (39) bezüglich der Gleichspannung umfasst.

7. Vorrichtung (45) zum Überwachen und Signalisieren des Fehlens der elektrischen Isolierung zwischen einer Antriebseinheit (29) und einer Karosserie (36) von elektrischen Fahrzeugen, welche Vorrichtung (45) einen Wechselspannungsgenerator (35), der zwischen der Antriebseinheit (29) und der Karosserie (36) liegt, eine Einrichtung (37) zum Erfassen des Stromes, der im Spannungsgenerator (35) fließt, und eine Einrichtung (39); (49), (51), (53) zum Bestimmen des Leckwiderstandes auf der Grundlage des Stromes und der Wechselspannung, die durch den Generator (35) erzeugt werden, wobei die Einrichtung (39); (49), (51), (53) zum Bestimmen des Leckwiderstandes erste Komparatoreinrichtungen (72), (73), die den Leckwiderstand mit einem ersten bestimmten Schwellenwert vergleichen und ein Signal für eine schlechte Isolierung ausgeben, wenn der Leckwiderstand unter dem ersten vorbestimmten Schwellenwert liegt, und zweite Komparatoreinrichtungen (74), (75) umfasst, die den Leckwiderstand mit einem zweiten vorbestimmten Schwellenwert vergleichen und ein Kurzschlusssignal ausgeben, wenn der Leckwiderstand unter dem zweiten vorbestimmten Schwellenwert liegt.

8. Vorrichtung nach Anspruch 7, **dadurch gekennzeichnet, dass** die Einrichtung (37) zum Erfassen des Stromes über eine kapazitive Einrichtung (38) von der Antriebseinheit (29) entkoppelt ist.

9. Vorrichtung nach Anspruch 7 oder 8, **dadurch gekennzeichnet, dass** die Einrichtung zum Erfassen des Stromes einen Nebenschlusswiderstand (37) umfasst, der in Reihe zum Spannungsgenerator (35) geschaltet ist.

10. Vorrichtung nach Anspruch 9, **dadurch gekennzeichnet, dass** die Einrichtung zum Bestimmen des Leckwiderstandes ein geeichtes Voltmeter (39) umfasst, das parallel zum Nebenschlusswiderstand (37) geschaltet ist.

11. Vorrichtung nach Anspruch 9, **dadurch gekennzeichnet, dass** die Einrichtungen (49), (51), (53) zum Bestimmen des Leckwiderstandes einen Messteil (58), der das Signal für die schlechte Isolierung und das Kurzschlusssignal erzeugen kann, einen Überwachungsteil (49), der Auslesefreigabesignale ausgeben kann, und einen Speicherteil (53) umfasst, der die Leckstromsignale beim Vorliegen der Auslesefreigabesignale speichern kann.

12. Vorrichtung nach Anspruch 11, **dadurch gekennzeichnet, dass** der Messteil (51) Differentialeinrichtungen (70) umfasst, um die Spannung über dem Nebenschlusswiderstand (37) zu bestimmen, und die ersten Komparatoreinrichtungen (72), (73) mit dem Ausgang der Differentialeinrichtungen (70) verbunden sind.

13. Vorrichtung nach Anspruch 12, **dadurch gekennzeichnet, dass** der Messteil (51) weiterhin die zweiten Komparatoreinrichtungen (74), (75) umfasst, die mit dem Ausgang der Differentialeinrichtungen (70) verbunden sind und das Kurzschlusssignal ausgeben können, wenn das Ausgangssignal der Differentialeinrichtungen größer als eine dritter, vorbestimmter Schwellenwert ist.

14. Vorrichtung nach einem der Ansprüche 11 bis 13, **dadurch gekennzeichnet, dass** der Überwachungsteil (49) Einrichtungen (64) bis (66) umfasst, die Spannungsstufen am Nebenschlusswiderstand (37) erfassen.

15. Vorrichtung nach Anspruch 14, **dadurch gekennzeichnet, dass** die Erfassungseinrichtungen (64) bis (66) dritte Komparatoreinrichtungen (65), (66) umfassen, die ein Stufensignal ausgeben können, wenn die Spannung am Nebenschlusswiderstand (37) einen vierten vorbestimmten Schwellenwert übersteigt, und dass der Überwachungsteil (49) auch Sperreinrichtungen (58) umfasst, die mit den dritten Komparatoreinrichtungen verbunden sind, und ein Zuverlässlichkeitsfenstersignal beim Fehlen des Stufensignals und mit einer vorbestimmten Verzögerung vom Ende des Stufensignals erzeugen können.

16. Vorrichtung nach Anspruch 15, **dadurch gekennzeichnet, dass** der Messteil (51) Differentialeinrichtungen (70) zum Erfassen der Spannung am Nebenschlusswiderstand (37) und erste Filtereinrichtungen (71) umfasst, die stromabwärts von den Differentialeinrichtungen angeordnet sind und eine erste Zeitkonstante aufweisen, und dass der Überwachungsteil (49) zweite Filtereinrichtungen (64) umfasst, die stromaufwärts von den dritten Komparatoreinrichtungen (65), (66) angeordnet sind und eine zweite Zeitkonstante haben, die kleiner als die erste Zeitkonstante ist.

**17.** Vorrichtung nach einem der Ansprüche 11 bis 16, **dadurch gekennzeichnet, dass** der Überwachungsteil (49) Spitzenwerterfassungseinrichtungen (59) umfasst, die mit dem Spannungsgenerator (35) verbunden sind, und Auslesephasensignale den Spitzen der Wechselspannung entsprechend erzeugen können.

**18.** Vorrichtung nach einem der Ansprüche 11 bis 17, **dadurch gekennzeichnet, dass** sie optische und/oder akustische Signalgebeeinrichtungen (90), (91) umfasst, die durch die Steuereinrichtungen (53) angesteuert werden.

**Revendications**

**1.** Procédé de contrôle et de signalisation de l'absence d'isolation électrique entre un groupe de traction (29) et une carrosserie (36) de véhicules électriques, le dit procédé comprenant les étapes d'application au dit groupe de traction (29) d'une tension alternative par rapport à la carrosserie (36) ; de détection d'un courant alternatif circulant à travers la dite carrosserie (36) sous l'effet de la dite tension alternative ; et de détermination de la valeur de toute résistance de fuite sur la base de la valeur du dit courant alternatif et de la dite tension alternative appliquée ; dans lequel la dite étape de détermination de la valeur de toutes les résistances de fuite comprend les étapes de comparaison de la résistance de fuite à un premier et un deuxième seuils prédéterminés, de signalisation d'un état d'isolation médiocre dans le cas où la résistance de fuite est inférieure au premier seuil prédéterminé, et de signalisation d'un état de court-circuit dans le cas où la résistance de fuite est inférieure au deuxième seuil prédéterminé.

**2.** Procédé selon la revendication 1, **caractérisé en ce que** la dite étape d'application d'une tension alternative comprend l'étape de connexion d'un générateur de tension alternative (35) au dit groupe de traction (29).

**3.** Procédé selon la revendication 2. **caractérisé en ce que** la dite étape de détection d'un courant alternatif comprend l'étape de connexion d'une résistance de shunt (37) de valeur connue en série avec le dit générateur de tension (35).

**4.** Procédé selon la revendication 3, **caractérisé en ce que** la dite étape de détermination de la valeur des résistances de fuite comprend l'étape de connexion d'un voltmètre étalonné (39) aux bornes de la dite résistance de shunt (37).

**5.** Procédé selon une des revendications 2 à 4, **caractérisé en ce que** la dite étape de détection d'un courant alternatif comprend l'étape d'élimination des composantes de courant continu présentes dans le dit groupe de traction (29).

**6.** Procédé selon la revendication 5, **caractérisé en ce que** la dite étape d'élimination des composantes de courant continu comprend l'étape de découplage du dit générateur de tension alternative (35) par rapport au dit groupe de traction (29) en ce qui concerne le courant continu.

**7.** Dispositif (45) de contrôle et de signalisation de l'absence d'isolation électrique entre un groupe de traction (29) et une carrosserie (36) de véhicules électriques, le dit dispositif (45) comprenant : un générateur de tension alternative (35) à connecter entre le dit groupe de traction (29) et la dite carrosserie (36) ; un moyen de détection (37) du courant qui circule dans le dit générateur de tension (35) ; et un moyen de détermination de la résistance de fuite (39 ; 49, 51, 53) sur la base du dit courant et de la dite tension alternative engendrée par le dit générateur (35) ; dans lequel le dit moyen de détermination de la résistance de fuite (39 ; 49, 51, 53) comprend des premiers moyens de comparaison (72, 73) pour comparer la résistance de fuite à un premier seuil prédéterminé et fournir un signal de mauvaise isolation dans le cas où la résistance de fuite est inférieure au premier seuil prédéterminé, et des deuxièmes moyens de comparaison (74, 75) pour comparer la résistance de fuite à un deuxième seuil prédéterminé et fournir un signal de court-circuit dans le cas où la résistance de fuite est inférieure au deuxième seuil prédéterminé.

**8.** Dispositif selon la revendication 7, **caractérisé en ce que** les dits moyens de détection de courant (37) sont isolés du dit groupe de traction (29) par des moyens capacitifs (38).

**9.** Dispositif selon la revendication 7 ou 8, **caractérisé en ce que** les dits moyens de détection du courant comprennent une résistance de shunt (37) disposée en série avec le dit générateur de tension (35).

**10.** Dispositif selon la revendication 9, **caractérisé en ce que** les dits moyens de détermination de la résistance de fuite comprennent un voltmètre étalonné (39) agencé en parallèle avec la dite résistance de shunt (37).

**11.** Dispositif selon la revendication 9, **caractérisé en ce que** les dits moyens de détermination de la résistance de fuite (49, 51, 53) comprennent une section de mesure (51) qui peut engendrer le dit signal de mauvaise isolation et le dit signal de court-circuit ; une section de contrôle (49) qui peut fournir des signaux de validation de lectue ; et une section de stockage (53) qui peut stocker le dit signal de fuite en la présence des dits signaux de validation de lecture.

12. Dispositif selon la revendication 11, **caractérisé en ce que** la dite section de mesure (51) comprend un circuit différentiel (70) pour déterminer la tension aux bornes de la dite résistance de shunt (37) et les dits premiers moyens de comparaison (72, 73) connectés à la sortie du dit circuit différentiel (70).

13. Dispositif selon la revendication 12, **caractérisé en ce que** la dite section de mesure (51) comprend en outre des deuxièmes moyens de comparaison (74, 75) qui sont connectés à la sortie du dit circuit différentiel (70) et qui peuvent fournir le dit signal de court-circuit dans le cas où un signal de sortie du dit circuit différentiel est plus grand qu'un troisième seuil prédéterminé.

14. Dispositif selon une des revendications 11 à 13, **caractérisé en ce que** la dite section de contrôle (49) comprend des moyens qui détectent des niveaux de tension continue (64-66) sur la dite résistance de shunt (37).

15. Dispositif selon la revendication 14, **caractérisé en ce que** les dits moyens de détection (64-66) comprennent des troisièmes moyens de comparaison (65, 66) qui peuvent fournir un signal de niveau de tension lorsque la dite tension à la dite résistance de shunt (37) dépasse un quatrième seuil prédéterminé, et **en ce que** la dite section de contrôle (49) comprend également des moyens d'interdiction (58) qui sont connectés aux dits troisièmes moyens de comparaison et qui peuvent engendrer un signal de fenêtre de fiabilité en l'absence du dit signal de niveau et avec un retard prédéterminé à partir de la fin du dit signal de niveau.

16. Dispositif selon la revendication 15, **caractérisé en ce que** la dite section de mesure (51) comprend un circuit différentiel (70) pour la détection de la tension à la dite résistance de shunt et des premiers moyens de filtrage (71) placés en aval du dit circuit différentiel et ayant une première constante de temps, et **en ce que** la dite section de contrôle (49) comprend des deuxièmes moyens de filtrage (64) placés en amont des dits troisièmes moyens de comparaison (65, 66) et ayant une deuxième constante de temps inférieure à la dite première constante de temps.

17. Dispositif selon une des revendications 11 à 16, **caractérisé en ce que** la dite section de contrôle (49) comprend des moyens de détection de crête (59) connectés au dit générateur de tension (35) et pouvant engendrer un signal de phase de lecture en correspondance avec les crêtes de la dite tension alternative.

18. Dispositif selon une des revendications 11 à 17, **caractérisé en ce qu'**il comprend des moyens de signalisation visuelle et/ou acoustique (90, 91) commandés par les dits moyens de stockage (53).

Fig.1

Fig.2

Fig.3

Fig. 4